# EUROPEAN PATENT APPLICATION

(11) **EP 2 903 101 A1**
(43) Date of publication of application: **05.08.2015**
(21) Application number: 13842589.7
(22) Date of filing: 25.09.2013
(51) Int. Cl.: H01R 13/6581

(54) **SHIELD CONNECTOR**

(30) Priority: 27.09.2012 JP 2012214160; 26.11.2012 JP 2012257277
(71) Applicant: Yazaki Corporation, Tokyo 108-0073 (JP)
(72) Inventor: YANAGIHARA, Yusuke, Kakegawa-shi Shizuoka 437-1421 (JP)
(74) Representative: Hoffmann Eitle
(86) International application number: PCT/JP2013/075816
(87) International publication number: WO 2014/050849

(57) **Abstract**

A shield connector (1) includes: a shield shell (5) having a cylindrical portion (3); a shield member (7) formed of a conductive metal foil to be placed on the outer circumference of the cylindrical portion (3); a ring (9) to be fastened on the outer circumference of the cylindrical portion (3) to fix the shield member (7) onto the cylindrical portion (3); and a flexible conductive member (11) to be interposed between the cylindrical portion (3) and the ring (9) so as to electrically connect the shield shell (5) and the shield member (7).

## Description

### TECHNICAL FIELD

The present invention relates to a shield connector.

### BACKGROUND ART

There is known a conventional shield connector including a shield shell having a cylindrical portion, a braided conductor serving as a shield member placed on an outer circumference of the cylindrical portion, and a shield ring fastened on the outer circumference of the cylindrical portion to fix the braided conductor onto the cylindrical portion (refer to PTL 1).

Such a conventional shield connector is attached to a housing for housing terminals connected to terminal portions of electric wires and covers the circumference of the electric wires drawn out of the housing so as to prevent entrance or leakage of noise or the like.

### CITATION LIST

### PATENT LITERATURE

PTL 1: JP 2009-087902 A

### SUMMARY

In the conventional shield connector, since the shield member is the braided conductor, there is a concern that noise components with high frequency may leak from gaps of the braided conductor. In order to deal therewith, a conductive metal foil may be applied to the shield member.

However, in the conventional shield connector, when a conductive metal foil is applied to the shield member and fixed to the cylindrical portion of the shield shell, there is a risk of causing wrinkles or breaks in the metal foil when the shield member is fastened by the ring.

As a result, appropriate contact pressure between the shield shell and the shield member cannot be ensured, which increases contact resistance therebetween to result in a decrease in shield performance.

An object of the present invention is to provide a shield connector capable of improving shield performance.

A shield connector according to a first aspect of the present invention includes: a shield shell having a cylindrical portion; a shield member formed of a conductive metal foil to be placed on an outer circumference of the cylindrical portion; a ring to be fastened on the outer circumference of the cylindrical portion to fix the shield member onto the cylindrical portion; and a flexible conductive member to be interposed between the cylindrical portion and the ring so as to electrically connect the shield shell and the shield member.

Since the shield member is formed of a conductive metal foil, and the flexible conductive member is interposed between the cylindrical portion and the ring, the conductive member is deformed when being fastened by the ring so as to decrease a load applied to the shield member and prevent damage of the shield member.

In addition, since the conductive member is deformed when being fastened by the ring, the shield member is connected to the shield shell with appropriate contact pressure via the conductive member so as to prevent an increase in contact resistance between the shield shell and the shield member.

Accordingly, the shield connector can improve shield performance while ensuring contact intensity between the shield shell and the shield member due to the conductive member.

The conductive member may be placed between the cylindrical portion and the shield member.

According to such a configuration, the contact area between the shield shell and the conductive member and the contact area between the shield member and the conductive member increase due to the deformation of the conductive member when being fastened by the ring so as to stabilize conductivity between the shield shell and the shield member.

The conductive member may be placed on the outer circumference of the shield member; and the shield member may be folded back to overlap the conductive member.

According to such a configuration, the shield member is connected to the shield shell while being in contact with the inner and outer circumferences of the conductive member. As a result, conductivity between the shield shell and the shield member can be stabilized.

A fixing portion may be provided between the cylindrical portion of the shield shell and the conductive member so as to position and fix the conductive member to the cylindrical portion.

According to such a configuration, the conductive member is prevented from moving on the cylindrical portion when the shield member and the ring are attached. Thus, attachment performance can be improved.

Accordingly, the shield connector can improve both the shield performance and the attachment performance concurrently.

The fixing portion may be formed on the outer circumference of the cylindrical portion and have a groove to which the conductive member is fitted.

According to such a configuration, the conductive member can be prevented from being displaced while the shield connector has a simple structure without an increase of the number of components.

The fixing portion may include a projection formed on one of the cylindrical portion and the conductive member and a recess formed on the other of the cylindrical portion and the conductive member so that the projection is fitted to the recess.

According to such a configuration, strength of the conductive member with respect to loads in multiple directions applied thereto can be improved, and strength to hold the conductive member can be improved.

According to the present invention, the shield connector capable of improving the shield performance can be provided.

### BRIEF DESCRIPTION OF DRAWINGS

Fig. 1 is an exploded perspective view of a shield connector according to a first embodiment.
Fig. 2(a) is a side view of the shield connector according to the first embodiment, and
Fig. 2(b) is an enlarged cross-sectional view of a main part of the shield connector according to the first embodiment.
Fig. 3 is a cross-sectional view of a shield connector according to a second embodiment.
Fig. 4 is an exploded perspective view of a shield connector according to a third embodiment.
Fig. 5 is a perspective view of a shield shell of the shield connector according to the third embodiment.
Fig. 6 is a perspective view of the shield connector according to the third embodiment to which a conductive member is attached.
Fig. 7 is an exploded perspective view of a shield connector according to a fourth embodiment.
Fig. 8 is a perspective view of a shield shell of the shield connector according to the fourth embodiment.
Figs. 9(a) and 9(b) are perspective views illustrating modified examples of the shield shell of the shield connector according to the fourth embodiment.

### DESCRIPTION OF EMBODIMENTS

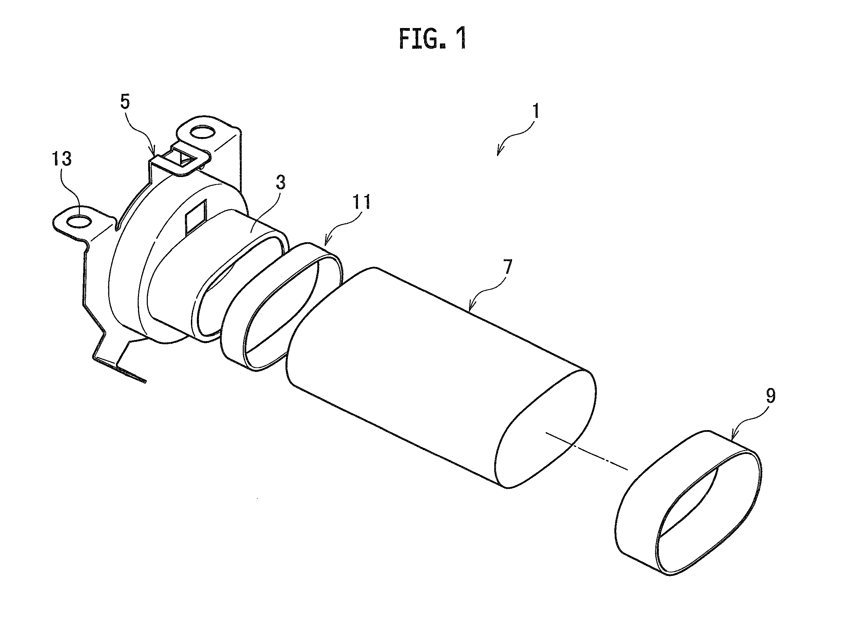

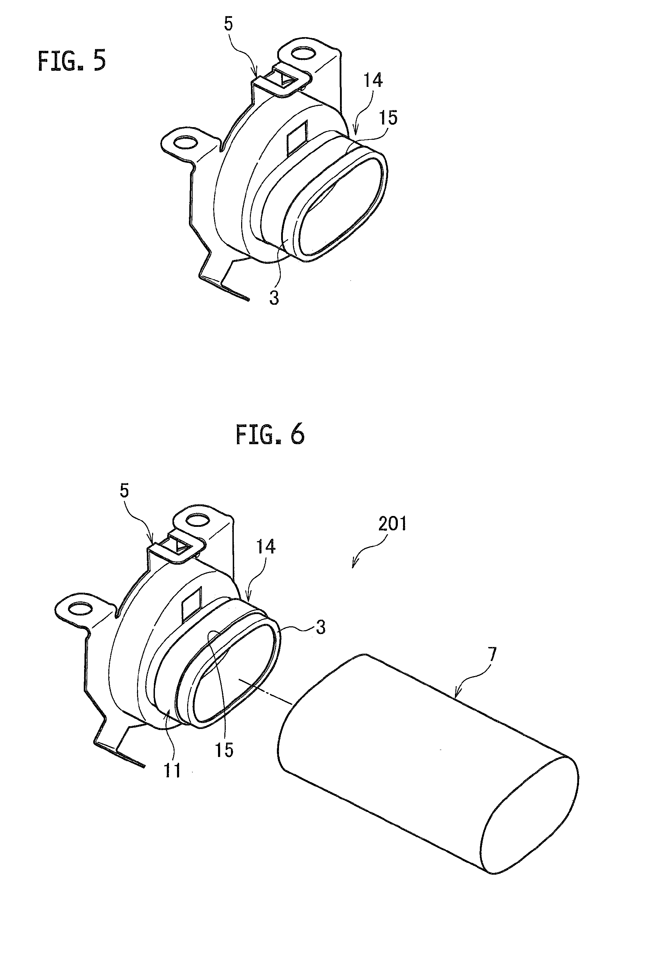

Shield connectors according to embodiments will be explained with reference to Fig. 1 to Fig. 9.

### (First Embodiment)

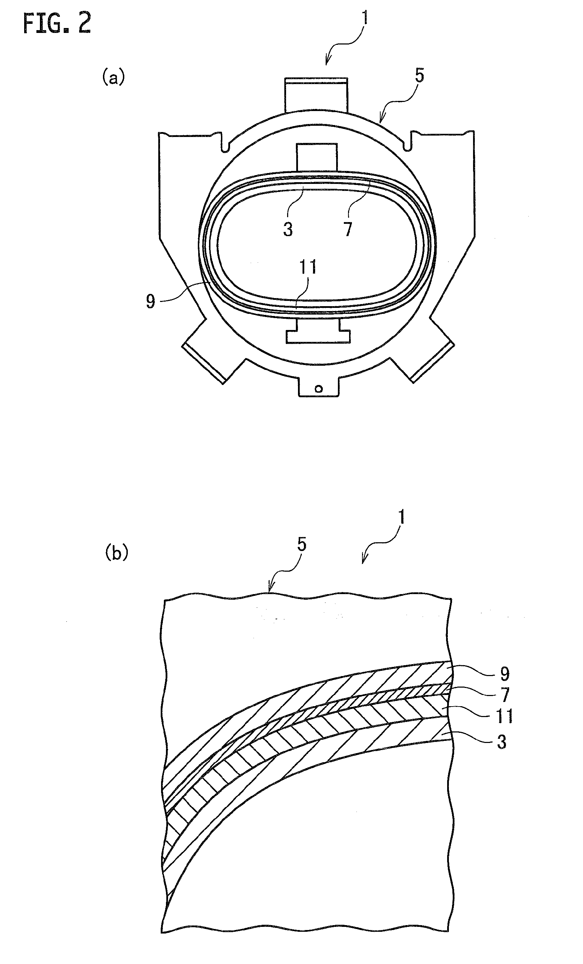

A shield connector 1 according to a first embodiment is explained below with reference to Figs. 1 and 2.

The shield connector 1 according to the first embodiment includes a shield shell 5 having a cylindrical portion 3, a shield member 7 placed on an outer circumference of the cylindrical portion 3, and a ring 9 fastened on the outer circumference of the cylindrical portion 3 to fix the shield member 7 onto the cylindrical portion 3.

The shield member 7 is formed of a conductive metal foil. A flexible conductive member 11 is interposed between the cylindrical portion 3 and the ring 9.

The conductive member 11 is placed between the cylindrical portion 3 and the shield member 7.

The shield connector 1 is attached, on an electric wire leading portion side, to a housing (not illustrated) for housing terminals connected to terminal portions of electric wires. The circumference of the electric wires drawn out of the housing is covered with the shield connector 1 so as to prevent entrance or leakage of noise or the like.

The shield connector 1 includes the shield shell 5, the shield member 7, the ring 9, and the conductive member 11.

The shield shell 5 is formed of a conductive material and attached to the housing on the electric wire leading portion side via a plurality of fixing portions 13. The shield shell 5 is provided with the cylindrical portion 3 into which the electric wires are inserted. The shield member 7 is placed on the outer circumference of the cylindrical portion 3.

The shield member 7 is formed of a sheet-like conductive metal foil and formed into a cylindrical shape. The shield member 7 is placed on the outer circumference of the cylindrical portion 3 of the shield shell 5 so as to cover the circumference of the electric wires drawn out of the housing.

The shield member 7 is electrically connected to the shield shell 5 to form a shield circuit for protecting the electric wires from entrance or leakage of noise or the like. The shield member 7 is fixed to the cylindrical portion 3 of the shield shell 5 with the ring 9.

The ring 9 is formed of a conductive material, placed on the outer circumference of the shield member 7 placed on the outer circumference of the cylindrical portion 3 of the shield shell 5, and fastens the shield member 7 onto the cylindrical portion 3 by use of a jig (not illustrated) or the like so as to form the shield circuit. The conductive member 11 is interposed between the ring 9 and the cylindrical portion 3.

The conductive member 11 is formed into a ring shape and formed of a flexible conductive material such as a gasket, a conductive rubber, or a sponge. The conductive member 11 is preferably formed of a conductive material having low specific resistance. The conductive member 11 is placed between the outer circumference of the cylindrical portion 3 of the shield shell 5 and the inner circumference of the shield member 7, and the shield shell 5 and the shield member 7 are electrically connected via the conductive member 11.

The conductive member 11 is elastically deformed in such a manner as to be fastened by the ring 9. The elastic deformation of the conductive member 11 disperses compressive force of the ring 9 applied to the shield member 7 so as to prevent wrinkles or breaks from being caused in the shield member 7. Accordingly, the shield shell 5 and the shield member 7 can be connected with appropriate contact pressure.

In addition, the elastic deformation of the conductive member 11 increases the contact areas between the outer circumferential surface of the cylindrical portion 3 of the shield shell 5 and the inner circumferential surface of the conductive member 11 and between the inner circumferential surface of the shield member 7 and the outer circumferential surface of the conductive member 11, so as to improve contact reliability between the shield shell 5 and the shield member 7.

In the shield connector 1, the shield member 7 is formed of a conductive metal foil, and the flexible conductive member 11 is interposed between the cylindrical portion 3 and the ring 9. Since the conductive member 11 is deformed when being fastened by the ring 9, a load applied to the shield member 7 decreases so as to prevent damage of the shield member 7.

In addition, since the conductive member 11 is deformed when being fastened by the ring 9, the shield member 7 is connected to the shield shell 5 with appropriate contact pressure via the conductive member 11. Thus, an increase in contact resistance between the shield shell 5 and the shield member 7 can be prevented.

Accordingly, the shield connector 1 can improve shield performance while ensuring contact intensity between the shield shell 5 and the shield member 7 due to the conductive member 11.

Since the conductive member 11 is placed between the cylindrical portion 3 and the shield member 7, the contact area between the shield shell 5 and the conductive member 11 and the contact area between the shield member 7 and the conductive member 11 both increase due to the deformation of the conductive member 11 when being fastened by the ring 9 so as to stabilize conductivity between the shield shell 5 and the shield member 7.

### (Second Embodiment)

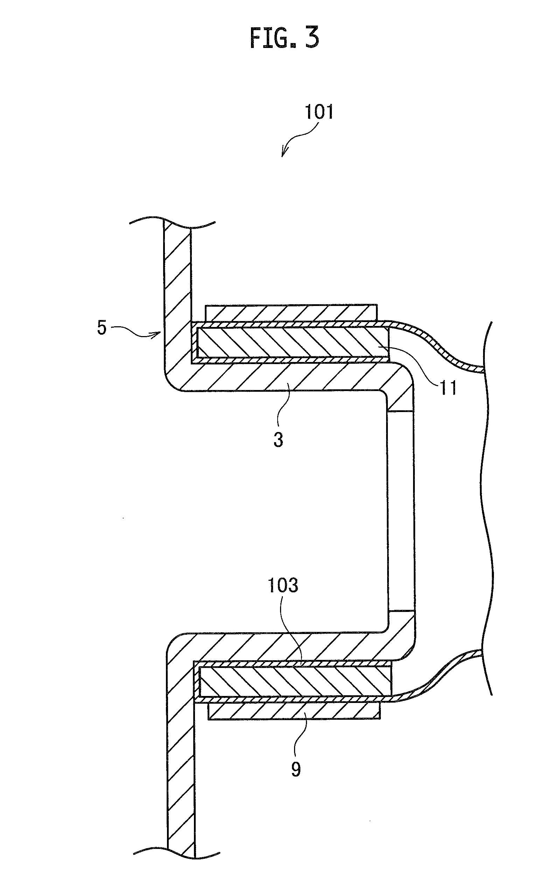

A shield connector 101 according to a second embodiment is explained below with reference to Fig. 3.

In the shield connector 101 according to the second embodiment, the conductive member 11 is placed on the outer circumference of a shield member 103, which is folded back to overlap the conductive member 11.

Note that, in the shield connector 101 according to the second embodiment, the same elements as those in the first embodiment are indicated by the same reference numerals, and the configurations and functions thereof are to be referred to the first embodiment and explanations thereof are not repeated below. Here, since the configurations are the same as those in the first embodiment, effects to be obtained are also the same as those in the first embodiment.

The conductive member 11 is placed on the outer circumference of the end portion of the shield member 103 placed on the outer circumference of the cylindrical portion 3 of the shield shell 5. The shield member 103 is folded back to surround the conductive member 11 and extend along the outer circumference of the conductive member 11 toward the leading portion of the electric wires.

The ring 9 is placed on the outer circumference of the shield member 103. The conductive member 11 is elastically deformed when being fastened by the ring 9, and the shield member 103 is fixed to the cylindrical portion 3 so as to form a shield circuit.

The elastic deformation of the conductive member 11 increases the contact areas between the inner and outer circumferential surfaces of the shield member 103 and the inner and outer circumferential surfaces of the conductive member 11, so as to improve contact reliability between the shield shell 5 and the shield member 103. In addition, the shield member 103 is folded back to extend along the outer circumference of the conductive member 11 toward the leading portion of the electric wires, so as to improve waterproof performance without the conductive member 11 exposed to the outside.

In the shield connector 101, the conductive member 11 is placed on the outer circumference of the shield member 103, and the shield member 103 is folded back to overlap the conductive member 11. Since the shield member 103 is connected to the shield shell 5 while being in contact with the inner and outer circumferences of the conductive member 11, the conductivity between the shield shell 5 and the shield member 103 can be stabilized.

In the shield connector according to the second embodiment of the present invention, although the shield member is folded back so as to extend along the outer circumference of the conductive member toward the leading portion of the electric wires, the shield member may be folded back so as to extend along the inner circumference of the conductive member toward the leading portion of the electric wires.

### (Third Embodiment)

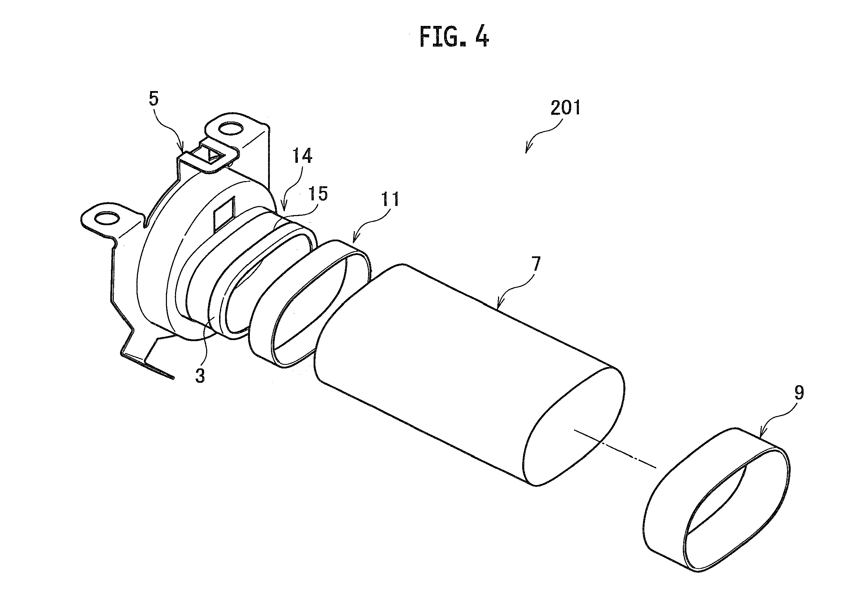

A third embodiment is explained below with reference to Figs. 4 to 6.

A shield connector 201 according to the third embodiment includes the shield shell 5 having the cylindrical portion 3, the shield member 7 formed of a conductive metal foil placed on the outer circumference of the cylindrical portion 3, the ring 9 fastened on the outer circumference of the cylindrical portion 3 to fix the shield member 7 onto the cylindrical portion 3, and the flexible conductive member 11 interposed between the cylindrical portion 3 and the ring 9 so as to electrically connect the shield shell 5 and the shield member 7.

A fixing portion 14 for positioning and fixing the conductive member 11 to the cylindrical portion 3 is formed between the cylindrical portion 3 of the shield shell 5 and the conductive member 11.

The fixing portion 14 includes a groove 15 on the outer circumference of the cylindrical portion 3 so that the conductive member 11 is fitted thereto.

The shield connector 201 is attached, on an electric wire leading portion side, to a housing (not illustrated) for housing terminals connected to terminal portions of electric wires. The circumference of the electric wires drawn out of the housing is covered with the shield connector 201 so as to prevent entrance or leakage of noise or the like.

The shield connector 201 includes the shield shell 5, the shield member 7, the ring 9, and the conductive member 11.

The shield shell 5 is formed of a conductive material and attached to the housing on the electric wire leading portion side via a plurality of fixing portions. The shield shell 5 is provided with the cylindrical portion 3 into which the electric wires are inserted. The shield member 7 is placed on the outer circumference of the cylindrical portion 3.

The shield member 7 is formed of a sheet-like conductive metal foil and formed into a cylindrical shape. The shield member 7 is placed on the outer circumference of the cylindrical portion 3 of the shield shell 5 so as to cover the circumference of the electric wires drawn out of the housing.

The shield member 7 is electrically connected to the shield shell 5 to form a shield circuit for protecting the electric wires from entrance or leakage of noise or the like. The shield member 7 is fixed to the cylindrical portion 3 of the shield shell 5 with the ring 9.

The ring 9 is formed of a conductive material, placed on the outer circumference of the shield member 7 placed on the outer circumference of the cylindrical portion 3 of the shield shell 5, and fastens the shield member 7 onto the cylindrical portion 3 by use of a jig (not illustrated) or the like so as to form the shield circuit. The conductive member 11 is interposed between the ring 9 and the cylindrical portion 3.

The conductive member 11 is formed into a ring shape and formed of a flexible conductive material such as a gasket, a conductive rubber, or a sponge. The conductive member 11 is preferably formed of a conductive material having low specific resistance. The conductive member 11 is placed between the outer circumference of the cylindrical portion 3 of the shield shell 5 and the inner circumference of the shield member 7, and the shield shell 5 and the shield member 7 are electrically connected via the conductive member 11.

The conductive member 11 is elastically deformed in such a manner as to be fastened by the ring 9. The elastic deformation of the conductive member 11 disperses compressive force of the ring 9 applied to the shield member 7 so as to prevent wrinkles or breaks from being caused in the shield member 7. Accordingly, the shield shell 5 and the shield member 7 can be connected with appropriate contact pressure.

In addition, the elastic deformation of the conductive member 11 increases the contact areas between the outer circumferential surface of the cylindrical portion 3 of the shield shell 5 and the inner circumferential surface of the conductive member 11 and between the inner circumferential surface of the shield member 7 and the outer circumferential surface of the conductive member 11, so as to improve contact reliability between the shield shell 5 and the shield member 7.

In the shield connector 1 according to the first embodiment, there is a case that the conductive member 11 placed on the outer circumference of the cylindrical portion 3 of the shield shell 5 moves in the longitudinal direction of the cylindrical portion 3 when the shield member 7 and the ring 9 are attached to the cylindrical portion 3, which may cause, in the worst case, a drop of the conductive member 11 from the cylindrical portion 3. In view of this, the shield connector 201 according to the third embodiment includes the fixing portion 14 located between the cylindrical portion 3 of the shield shell 5 and the conductive member 11 so as to position and fix the conductive member 11 onto the cylindrical portion 3.

The fixing portion 14 includes the groove 15 continuously formed in the circumferential direction on the outer circumference of the cylindrical portion 3 of the shield shell 5. The conductive member 11 is closely fitted onto the groove 15 on the outer circumference of the cylindrical portion 3. Since the conductive member 11 is fitted onto the groove 15, the conductive member 11 is prevented from moving in the longitudinal direction of the cylindrical portion 3 so that the conductive member 11 is positioned and fixed onto the cylindrical portion 3.

In the shield connector 201, the flexible conductive member 11 is interposed between the cylindrical portion 3 and the ring 9. Since the conductive member 11 is deformed when being fastened by the ring 9, a load applied to the shield member 7 decreases so as to prevent damage of the shield member 7 to improve shield performance.

The fixing portion 14 for positioning and fixing the conductive member 11 onto the cylindrical portion 3 is located between the cylindrical portion 3 of the shield shell 5 and the conductive member 11. Thus, the conductive member 11 is prevented from moving on the cylindrical portion 3 at the time of attachment of the shield member 7 and the ring 9, which improves attachment performance.

Accordingly, the shield connector 201 can improve both the shield performance and the attachment performance concurrently.

Since the fixing portion 14 includes the groove 15 on the outer circumference of the cylindrical portion 3 to which the conductive member 11 is fitted, the conductive member 11 can be prevented from being displaced while the shield connector 201 has a simple structure without an increase of the number of components.

### (Fourth Embodiment)

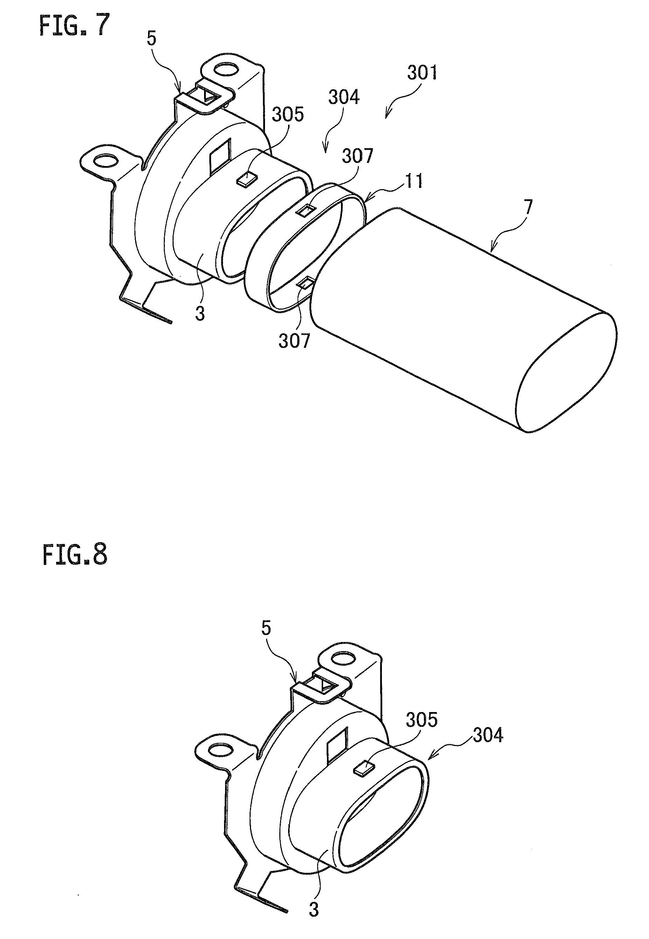

A fourth embodiment is explained below with reference to Figs. 7 and 8.

A shield connector 301 according to the fourth embodiment includes a fixing portion 304, which includes projections 305 formed on the cylindrical portion 3 and recesses 307 formed in the conductive member 11 so that the projections 305 are fitted thereto.

Note that the same elements as those in the third embodiment are indicated by the same reference numerals, and the configurations and functions thereof are to be referred to the third embodiment and explanations thereof are not repeated below. Here, since the configurations are the same as those in the third embodiment, effects to be obtained are also the same as those in the third embodiment.

The fixing portion 304 includes the projections 305 and the recesses 307. The projections 305 project on the respective upper and lower surfaces (the projection on the upper surface is only illustrated) of the outer circumference of the cylindrical portion 3 of the shield shell 5. The projections 305 are fitted to the recesses 307 in the state where the conductive member 11 is attached to the cylindrical portion 3.

The recesses 307 are holes penetrating the respective upper and lower surfaces of the conductive member 11. The recesses 307 and the projections 305 are fitted together in a manner such that the conductive member 11 is attached to the outer circumference of the cylindrical portion 3 of the shield shell 5. The projections 305 and the recesses 307 fitted together can position and fix the conductive member 11 onto the cylindrical portion 3 without the conductive member 11 moving on the outer circumference of the cylindrical portion 3.

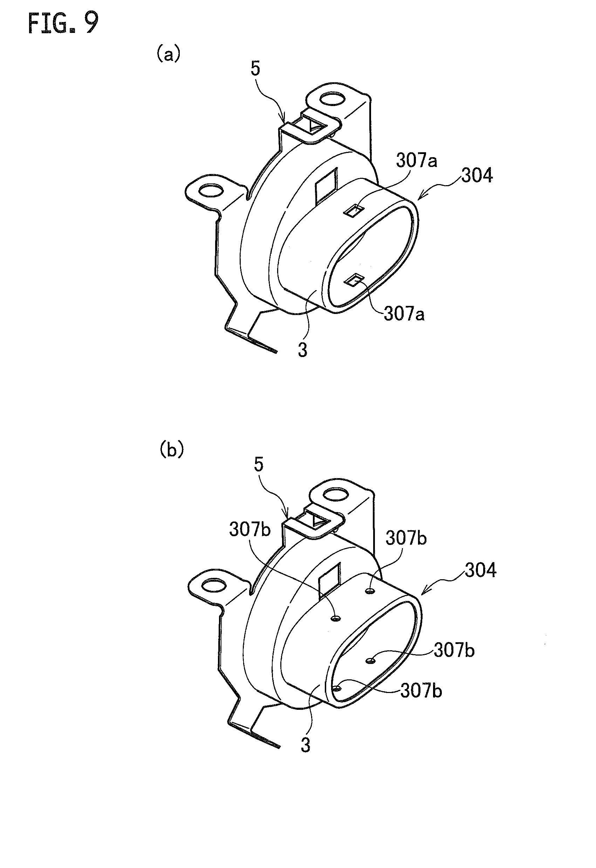

Alternatively, the cylindrical portion 3 of the shield shell 5 may be provided with, for example, recesses 307a each formed into an elongated hole as illustrated in Fig. 9(a) or recesses 307b that are a plurality of holes (four in this case) as illustrated in Fig. 9(b). In either case, projections may be formed on the inner circumferential surface of the conductive member 11 so as to be fitted to the recesses 307a or the recesses 307b. The relationship between the projections and the recesses described above can also position and fix the conductive member 11 onto the cylindrical portion 3.

In the shield connector 301, the fixing portion 304 includes the projections 105 formed on the cylindrical portion 3 and the recesses 107 formed in the conductive member 11 so that the projections 105 are fitted thereto. Thus, the shield connector 301 can improve strength of the conductive member 11 with respect to loads in multiple directions applied thereto and also improve strength to hold the conductive member 11.

In the shield connectors according to the third embodiment and the fourth embodiment, the configurations were exemplified each including the fixing portion provided with the groove, projections and recesses separately. However, the shield connectors are not limited to the configurations described above and may have a configuration in which the groove is provided with projections or recesses and the conductive member is provided with recesses or projections.

The shape of the groove is not limited to that continuously formed in the circumferential direction of the cylindrical portion and may be any groove such as an intermittent groove formed on the upper and lower surfaces of the cylindrical portion as long as it can be fitted to the outer shape of the conductive member.

The projections are provided at plural portions on the cylindrical portion, but the present invention is not limited thereto and may have any configuration as long as the projections and recesses can be fitted together, such as a configuration in which a continuous projection may be formed in the circumferential direction of the cylindrical portion, and a recess to be fitted to the projection may be formed in the conductive member, or in which continuous projections may be formed in rows in the longitudinal direction of the cylindrical portion.

### INDUSTRIAL APPLICABILITY

The present invention can provide a shield connector capable of improving shield performance.

## Claims

1. A shield connector, comprising:
a shield shell having a cylindrical portion;
a shield member formed of a conductive metal foil to be placed on an outer circumference of the cylindrical portion;
a ring to be fastened on the outer circumference of the cylindrical portion to fix the shield member onto the cylindrical portion; and
a flexible conductive member to be interposed between the cylindrical portion and the ring so as to electrically connect the shield shell and the shield member.

2. The shield connector according to claim 1, wherein the conductive member is placed between the cylindrical portion and the shield member.

3. The shield connector according to claim 1, wherein
the conductive member is placed on an outer circumference of the shield member, and
the shield member is folded back to overlap the conductive member.

4. The shield connector according to claim 1, further comprising a fixing portion located between the cylindrical portion and the conductive member so as to position and fix the conductive member to the cylindrical portion.

5. The shield connector according to claim 4, wherein the fixing portion is formed on the outer circumference of the cylindrical portion and has a groove to which the conductive member is fitted.

6. The shield connector according to claim 4, wherein the fixing portion includes a projection formed on one of the cylindrical portion and the conductive member and a recess formed on the other of the cylindrical portion and the conductive member so that the projection is fitted to the recess.
